Europäisches Patentamt

European Patent Office

Office européen des brevets

(19)

(11) Veröffentlichungsnummer: **0 320 706 B1**

(12)

# EUROPÄISCHE PATENTSCHRIFT

(45) Veröffentlichungstag der Patentschrift: **01.07.92**

(51) Int. Cl.⁵: **C23C 14/02**

(21) Anmeldenummer: **88120081.0**

(22) Anmeldetag: **01.12.88**

(54) Verfahren zur Herstellung korrosions-, verschleiss- und pressfester Schichten.

(30) Priorität: **14.12.87 DE 3742317**

(43) Veröffentlichungstag der Anmeldung:
**21.06.89 Patentblatt 89/25**

(45) Bekanntmachung des Hinweises auf die
Patenterteilung:
**01.07.92 Patentblatt 92/27**

(84) Benannte Vertragsstaaten:
**AT BE CH DE ES FR GB GR IT LI LU NL SE**

(56) Entgegenhaltungen:
**FR-A- 2 513 660**
**GB-A- 2 192 196**

**PATENT ABSTRACTS OF JAPAN, Band 11,
Nr. 75 (C-408)[2522], 6. März 1987; & JP-A-61
231 158 (HITACHI METALS LTD) 15-10-1986**

**HÄRTEREI-TECHNISCHE MITTEILUNGEN,
Band 37, Nr. 6, November-Dezember 1982,
Seiten 263-269, München, DE; H. WILHELMI et
al.: "Nitrieren mit gepulster Glimmentladung"**

(73) Patentinhaber: **Repenning, Detlev, Dr.
Krabbenhöhe 12
W-2057 Reinbek(DE)**

(72) Erfinder: **Repenning, Detlev, Dr.
Krabbenhöhe 12
W-2057 Reinbek(DE)**

(74) Vertreter: **Niedmers, Ole, Dipl.-Phys. et al
Patentanwälte Niedmers & Schöning Jessenstrasse 4
W-2000 Hamburg 50(DE)**

EP 0 320 706 B1

**Beschreibung**

Die Erfindung betrifft eine Verfahren zur Herstellung korrosions-, verschleiß- und preßfester Schichten auf einem metallischen Substrat (Werkstück) unter Anwendung des PVD-Verfahrens, wobei das Substrat in einem ersten Schritt einer Diffusionshärtung unterzogen wird und nachfolgend unter Anwendung eines PVD-Verfahrens auf die durch Diffusionshärtung gebildete Schicht eine hochharte Endschicht aufgebracht wird.

Im gesamten Bereich der Technik treten bei vielen Gleitund Reibpaarungen am jeweiligen Gegenkörper des Paares hohe Preßdrücke auf, mit der Folge, daß der das Substrat bildende Werkstoff stark verformt wird. Dies gilt insbesondere auch für Werkstoffe, die entweder überhaupt nicht härtbar sind oder bei Härtung ihre Korrosionsbeständigkeit verlieren würden, wie z.B. die gesamte Klasse der hochlegierten, nichtrostenden Edelstähle. Aus diesem Grunde fällt die Härtungsmöglichkeit für die vorgenannte Werkstoffklasse aus, mit der Folge, daß diese bei den obengenannten Bedingungen eine starke Verformung bei hohen Preßdrücken zeigen.

Um dieses Problem zu lösen, wurde bisher versucht, das Substrat hart zu verchromen oder mittels einer Schicht zu versehen, die aus flamm- oder plasmagespritztem Aluminium- oder Titanoxid gebildet ist. Auch wurde versucht, dick vernickelte Schichten zu bilden oder aber Schichten mittels Anwendung des CVD-Verfahrens herzustellen.

Alle bisherigen Schichten weisen den großen Nachteil auf, daß sie entweder eine zu geringe Härte aufweisen oder aber die in den meisten Fällen notwendigerweise einzuhaltenden Maßtoleranzen nicht gewährleisten können. Hinzu kommt noch, daß die vorgenannten Schichten zudem mit einer hohen Temperatur aufgebracht werden müssen, die wiederum vielfach nachteilig für das kristalline Gefüge des Substrats ist.

Um diese bekannten Nachteile zu überwinden, wurde auch versucht, das Substrat mit Hartstoffschichten, beispielsweise Titancarbid, Titannitrid usw. zu versehen, deren Härte einerseits sehr hoch und deren Reibwerte andererseits der zu erwartenden Beanspruchung anpaßbar sind.

Auch diese Schichten haben jedoch den Nachteil, daß sie in den allermeisten Fällen zu dünn sind, mit der Folge, daß auf einem weichen Substratgrundwerkstoff diese Schichten bei hohem Preßdrücken schnell bei gleitender Beanspruchung weggedrückt werden.

Ein Verfahren der eingangs genannten Art zur Herstellung verschleißfester zweilagiger Schichten ist bekannt (JP-A-61 231 158).

Es ist Aufgabe der vorliegenden Erfindung ein Verfahren zu schaffen, mit dem Schichten hergestellt werden können, die sowohl korrosions-, verschleiß- als auch preßfest sind und auf einem metallischem Substrat aufgebracht werden können. Darüber hinaus soll das Verfahren auch aufgabengemäß einfach und sicher durchführbar sein.

Gelöst wird die Aufgabe gemäß der Erfindung dadurch, daß auf die durch Diffusionshärtung gebildete Schicht unter Anwendung eines PVD-Verfahrens zunächst eine Zwischenschicht aufzubringen, auf die nachfolgend dann die hochharte Endschicht aufgebracht wird.

Der Vorteil des erfindungsgemäßen Verfahrens liegt im wesentlichen darin, daß durch unmittelbar aufeinanderfolgende Ausbildung der die Gesamtschicht bildenden Teilschichten das zu beschichtende metallische Substrat, d.h. das Werkstück, aufgabengemäß preßfest ist, und zwar durch Ausbildung einer durch Diffusionshärtung erzeugten Schicht, verschleißfest ist durch Ausbildung der hochharten Endschicht und korrosionsfest durch Ausbildung der Zwischenschicht.

Gemäß einer vorteilhaften Ausgestaltung des Verfahrens erfolgt die Diffusionshärtung unter Anwendung eines Nitrierverfahrens, wobei das Nitrierverfahren vorzugsweise das Gas- oder Salzbadnitrieren ist. Es sei erwähnt, daß sich auch andere klassische Diffusionshärteverfahren zur Ausbildung der ersten Schicht eignen.

Gemäß einer anderen vorteilhaften Ausgestaltung des Verfahrens erfolgt die Diffusionshärtung unter Anwendung der Puls-Plasma-Technik. Bei Anwendung dieser Technik wird das zu beschichtende Substrat in einem Vakuumrezipienten auf pulsierende negative Spannung gelegt und in einer Stickstoff-, $CO_2$-Atmosphäre oder in einer geeigneten anderen Atmosphäre nitriert, carbooxidiert o. dgl.. Die Diffusionstemperaturen liegen dabei ab ca. 300 °C vergleichsweise niedrig.

Vorteilhafterweise wird das zur Ausbildung der Zwischenschicht und der Endschicht angewandte PVD-Verfahren durch das Sputter- oder Arc-Ionplating-Verfahren gebildet, wobei hervorzuheben ist, daß sich grundsätzlich dafür aber auch alle anderen unter das PVD-Verfahren generell einzuordnenden Verfahren eignen.

Die durch Anwendung des Diffusionsverfahren gebildete Schicht weist vorteilhafterweise eine Dikke von $3 \times 10^{-2}$ bis $1,2 \times 10^{-1}$ mm auf, wobei deren Härte zwischen 700 und 1200 HV liegt. Die hochharte Endschicht weist vorzugsweise eine Dikke von $10^{-4}$ bis $6 \times 10^{-3}$mm auf, wobei auch hier darauf hinzuweisen ist, daß die vorgenannten Dikkenangaben der Schichten in Abhängigkeit des konkreten Anwendungsfalles natürlich auch andere Dicken haben können, je nach dem, welcher Parameter (Korrosionsfestigkeit, Verschleißfestigkeit, Preßfestigkeit) als die Eigenschaft der Gesamtschicht wesentlich bestimmender Parameter gewünscht ist.

Zur Ausbildung der Zwischenschicht wird vorteilhafterweise Chrom verwendet, es hat sich jedoch auch gezeigt, daß zur Ausbildung der Zwischenschicht mit Palladium dotiertes Titan vorteilhaft ist, insbesondere wenn der Palladiumanteil dabei 0,15% beträgt. Eine andere Zwischenschicht wird vorteilhafterweise aus Tantal gebildet.

Die äußere Endschicht wird gemäß einer weiteren vorteilhaften Ausgestaltung des Verfahrens durch Hartstoffschichten auf carbidischer, nitridischer, carbonnitridischer oder kohlenstoffhaltiger Basis gebildet. Dabei hängt die Wahl der vorgenannten unterschiedlichen, die Hartstoffschicht bildenden Stoffe von der gewünschten physikalischen und/oder chemischen Eigenschaft ab, die die Endschicht im konkreten Anwendungsfall haben soll.

Als besonders vorteilhaft erweist es sich bei der Ausführung des Verfahrens, daß die Ausbildung der Schichten in einer (einzigen) Kammer erfolgen kann, wobei die Ausbildung der durch Diffusionshärtung gebildeten Schicht bei einem Diffusionsgasdruck im Inneren der Kammer von $5 \times 10^{-6}$ bis $5 \times 10^{-5}$ bar erfolgt, die nachfolgende Ausbildung der Zwischen- und Endschicht hingegen bei einem Innendruck der Kammer von $5 \times 10^{-7}$ bar.

Die Erfindung wird nun anhand eines Ausführungsbeispieles im einzelnen beschrieben.

Bei der Ausführung des Verfahrens wird das zu beschichtende metallische Substrat, d.h. das bzw. die Werkstücke in die Kammer eingegeben, wobei das Diffusionsgas, das für den ersten Verfahrensschritt der Ausbildung einer Schicht mittels Diffusionshärtung auf einen Druck zwischen $5 \times 10^{-6}$ bis $2 \times 10^{-5}$ bar eingestellt wird. Durch Anlegen einer pulsierenden Spannung von beispielsweise -kV Maximalwert wird das metallische Substrat diffusionsgehärtet, wobei grundsätzlich alle bekannten Diffusionshärteverfahren zur Ausbildung der ersten Schicht, beispielsweise Salzbadnitrieren, Gasnitrieren, Puls- Plasmatechnik u. dgl. angewendet bzw. verwendet werden können.

Die sich mittels des Diffusionshärteverfahrens ausbildende Schicht ist vorzugsweise $3 \times 10^{-2}$ bis $1,2 \times 10^{-1}$ mm dick.

Durch den Diffusionshärtevorgang verliert der das Substrat bildende Werkstoff in der Regel seine Korrosionsfestigkeit. Um das metallische Substrat dennoch insgesamt korrosionsfest zu machen, wird nachfolgend die Kammer zunächst auf einen Druck von $5 \times 10^{-7}$ bar evakuiert, so daß dann nachfolgend zunächst durch Aufbringen einer Zwischenschicht mittels des obengenannten PVD-Verfahrens die ursprüngliche Korrosionsbeständigkeit des Substrats wiederhergestellt wird. Die Zwischenschicht wird dabei vorzugsweise aus Chrom, Tantal, Titan oder aus mit Palladium dotiertem Titan gebildet.

Die Zwischenschicht braucht lediglich nur so dick ausgebildet werden, daß die Korrosionsfestigkeit des durch Diffusionshärtung nicht mehr Korrosionsfesten Substrats wiederhergestellt wird. Bei der Ausbildung der Zwischenschicht muß die Bildung eines äußeren porösen Saumes vermieden werden.

Bei gleichem Innendruck in der Beschichtungskammer ($5 \times 10^{-7}$ bar) erfolgt die Ausbildung der Hartstoffschicht, die auf carbidischer, nitridischer, carbonnitridischer oder kohlenstoffhaltiger Basis erzeugt wird. Als Beschichtungsverfahren zur Ausbildung der hochharten Endschicht eignet sich ebenso wie bei der Ausbildung der vorbeschriebenen Zwischenschicht jedes unter das PVD-Verfahren fallende Beschichtungsverfahren, beispielsweise das Sputter- oder das Arc-Ionplating-Verfahren.

Mit dem erfindungsgemäßen Verfahren sind Schichten auf dem metallischen Substrat bildbar, die korrosionsfest und hoch verschleißbeständig bei gleichzeitig auftretenden hohen Flächendrücken sind.

**Patentansprüche**

1. Verfahren zur Herstellung korrosions-, verschleißund preßfester Schichten auf einem metallischen Substrat (Werkstück) unter Anwendung des PVD-Verfahrens, wobei das Substrat in einem ersten Schritt einer Diffusionshärtung unterzogen wird und nachfolgend unter Anwendung eines PVD-Verfahrens auf die durch Diffusionshärtung gebildete Schicht eine hochharte Endschicht aufgebracht wird, dadurch gekennzeichnet, daß auf die durch Diffusionshärtung gebildete Schicht unter Anwendung eines PVD-Verfahrens zunächst eine Zwischenschicht aufgebracht wird, auf die nachfolgend dann die hochharte Endschicht aufgebracht wird.

2. Verfahren nach Anspruch 2, dadurch gekennzeichnet, daß die Diffusionshärtung unter Anwendung eines Nitrierverfahrens erfolgt.

3. Verfahren nach Anspruch 2, dadurch gekennzeichnet, daß das Nitrierverfahren Gas- oder Salzbadnitrieren ist.

4. Verfahren nach einem oder mehreren der Ansprüche 1 bis 3, dadurch gekennzeichnet, daß die Diffusionshärtung unter Anwendung der Puls-Plasma-Technik erfolgt.

5. Verfahren nach einem oder mehreren der Ansprüche 1 bis 4, dadurch gekennzeichnet, daß ein zur Ausbildung der Zwischenschicht und der Endschicht angewandtes PVD-Verfahren das Sputter- oder das Arc-Ionplating-Verfahren

ist.

6. Verfahren nach einem oder mehreren der Ansprüche 1 bis 5, dadurch gekennzeichnet, daß die durch Anwendung des Diffusionsverfahrens gebildete Schicht eine Dicke von $3 \times 10^{-2}$ bis $1,2 \times 10^{-1}$mm aufweist, deren Härte zwischen 700 bis 1200 HV liegt.

7. Verfahren nach einem oder mehreren der Ansprüche 1 bis 6, dadurch gekennzeichnet, daß die hochharte Endschicht eine Dicke von $10^{-4}$ bis $6 \times 10^{-3}$mm aufweist.

8. Verfahren nach einem oder mehreren der Ansprüche 1 bis 7, dadurch gekennzeichnet, daß die Zwischenschicht Chrom ist.

9. Verfahren nach einem oder mehreren der Ansprüche 1 bis 8, dadurch gekennzeichnet, daß die Zwischenschicht mit Palladium dotiertes Titan ist.

10. Verfahren nach Anspruch 9, dadurch gekennzeichnet, daß der Palladiumanteil 0,15% beträgt.

11. Verfahren nach einem oder mehreren der Ansprüche 1 bis 7, dadurch gekennzeichnet, daß die Zwischenschicht Tantal ist.

12. Verfahren nach einem oder mehreren der Ansprüche 1 bis 11, dadurch gekennzeichnet, daß die Endschicht durch Hartstoffschichten auf carbidischer, nitridischer, carbonnitridischer oder kohlenstoffhaltiger Basis gebildet wird.

13. Verfahren nach einem oder mehren der Ansprüche 1 bis 12, dadurch gekennzeichnet, daß die Schichten in einer Kammer ausgebildet werden, und daß die Ausbildung der durch Diffusionshärtung gebildeten Schicht bei einem Diffusionsgasdruck im Inneren der Kammer von $5 \times 10^{-6}$ bis $5 \times 10^{-5}$ bar erfolgt, wobei die nachfolgende Ausbildung der Zwischen- und Endschicht bei einem Innendruck der Kammer von $5 \times 10^{-7}$ bar erfolgt.

**Claims**

1. A method of producing corrosion, wear and pressure-resistant coatings on a metallic substrate (workpiece) by applying the PVD method, the substrate being subjected to a diffusion hardening process in a first stage after which a final high-hardness coating is applied by the application of a PVD process to the coating formed by diffusion hardening, characterised in that by the application of a PVD process, firstly an intermediate coating is applied to the coating formed by diffusion hardening and a high-hardness final coating is then applied thereto.

2. A method according to Claim 2, characterised in that diffusion hardening is carried out by the application of a nitrating process.

3. A method according to Claim 2, characterised in that the nitrating process is gas or salt bath nitration.

4. A method according to one or more of Claims 1 to 3, characterised in that diffusion hardening is carried out by the application of pulse-plasma technology.

5. A method according to one or more of Claims 1 to 4, characterised in that the sputter or ion plating method is a PVD process which is applied in order to form the intermediate coating and the final coating.

6. A method according to one or more of Claims 1 to 5, characterised in that the coating formed by applying the diffusion process has a thickness of $3 \times 10^{-2}$ to $1.2 \times 10^{-1}$ mm, its hardness being between 700 and 1200 HV.

7. A method according to one or more of Claims 1 to 6, characterised in that the high-hardness final coating has a thickness of $10^{-4}$ to $6 \times 10^{-3}$ mm.

8. A method according to one or more of Claims 1 to 7, characterised in that the intermediate coating is chrome.

9. A method according to one or more of Claims 1 to 8, characterised in that the intermediate coating is palladium-doped titanium.

10. A method according to Claim 9, characterised in that the palladium fraction amounts to 0.15%.

11. A method according to one or more of Claims 1 to 7, characterised in that the intermediate coating is tantalum.

12. A method according to one or more of Claims 1 to 11, characterised in that the final coating is formed by coatings of hard carbon nitride or carbon-containing material.

13. A method according to one or more of Claims 1 to 12, characterised in that the coatings are formed in a chamber and in that the formation of the coating formed by diffusion hardening is made when the diffusion gas pressure inside the chamber is $5 \times 10^{-6}$ to $5 \times 10^{-5}$ bars, the subsequent formation of the intermediate and final coatings taking place at an internal pressure of $5 \times 10^{-7}$ bars inside the chamber.

## Revendications

1. Procédé pour fabriquer des couches résistantes à la corrosion, à l'usure et à la compression sur un substrat métallique (pièce à traiter) moyennant l'utilisation du procédé PVD, selon lequel, lors d'une première étape opératoire, on soumet le substrat à un durcissement par diffusion et ensuite, en utilisant un procédé PVD, on dépose une couche finale extrêmement dure sur la couche formée par durcissement par diffusion, caractérisé en ce que sur la couche formée par durcissement par diffusion, on dépose tout d'abord, moyennant l'utilisation d'un procédé PVD, une couche intercalaire, sur laquelle on dépose ensuite la couche finale extrêmement dure.

2. Procédé selon la revendication 2, caractérisé en ce que le durcissement par diffusion est réalisé moyennant l'utilisation d'un procédé de nitruration.

3. Procédé selon la revendication 2, caractérisé en ce que le procédé de nitruration est une nitruration au gaz ou avec un bain salin.

4. Procédé selon une ou plusieurs des revendications 1 à 3, caractérisé en ce que le durcissement par diffusion est réalisé moyennant l'utilisation de la technique plasmatique à impulsions.

5. Procédé selon une ou plusieurs des revendications 1 à 4, caractérisé en ce qu'un procédé PVD utilisé pour former la couche intercalaire et la couche finale est le procédé de pulvérisation ou le procédé de placage ionique à arc.

6. Procédé selon une ou plusieurs des revendications 1 à 5, caractérisé en ce que la couche formée moyennant l'utilisation du procédé de diffusion possède une épaisseur comprise entre $3 \times 10^{-2}$ et $1,2 \times 10^{-1}$ mm et sa dureté est comprise entre 700 et 1200 HV.

7. Procédé selon une ou plusieurs des revendications 1 à 6, caractérisé en ce que la couche finale extrêmement dure possède une épaisseur comprise entre $10^{-4}$ et $6 \times 10^{-3}$ mm.

8. Procédé selon une ou plusieurs des revendications 1 à 7, caractérisé en ce que la couche intercalaire est formée de chrome.

9. Procédé selon une ou plusieurs des revendications 1 à 8, caractérisé en ce que la couche intercalaire est formée de titane dopé par du palladium.

10. Procédé selon la revendication 9, caractérisé en ce que le pourcentage de palladium est égal à 0,15 %.

11. Procédé selon une ou plusieurs des revendications 1 à 7, caractérisé en ce que la couche intercalaire est formée de tantale.

12. Procédé selon une ou plusieurs des revendications 1 à 11, caractérisé en ce que la couche finale est formée par des couches d'un matériau dur à base de carbure, de nitrure, de carbonitrure ou contenant du carbone.

13. Procédé selon une ou plusieurs des revendications 1 à 12, caractérisé en ce que les couches sont formées dans une chambre et que la formation de la couche par durcissement par diffusion s'effectue avec une pression du gaz de diffusion comprise entre $5 \times 10^{-6}$ et $5 \times 10^{-5}$ bars à l'intérieur de la chambre, la formation ultérieure de la couche intercalaire et de la couche finale s'effectuant avec une pression intérieure égale à $5 \times 10^{-7}$ bars dans la chambre.